# EUROPÄISCHE PATENTSCHRIFT

(11) **EP 1 258 064 B1**
(45) Veröffentlichungstag und Bekanntmachung des Hinweises auf die Patenterteilung: **06.04.2011**
(21) Anmeldenummer: 01925294.9
(22) Anmeldetag: 23.02.2001
(51) Int. Cl.: H01S 5/223, H01S 5/323

(54) **VERFAHREN ZUR HERSTELLUNG EINES HALBLEITERBAUELEMENTS FÜR DIE EMISSION ELEKTROMAGNETISCHER STRAHLUNG**
METHOD FOR PRODUCTION OF A SEMICONDUCTOR COMPONENT FOR THE EMISSION OF ELECTROMAGNETIC RADIATION
PROCEDE DE PRODUCTION D'UN COMPOSANT SEMI-CONDUCTEUR PERMETTANT L'EMISSION DE RAYONNEMENT ELECTROMAGNETIQUE

(30) Priorität: 24.02.2000 DE 10008584
(43) Veröffentlichungstag der Anmeldung: 20.11.2002
(73) Patentinhaber: OSRAM Opto Semiconductors GmbH, 93055 Regensburg (DE)
(72) Erfinder: LELL, Alfred, 93142 Maxhütte-Haidhof (DE); LUFT, Johann, 93195 Wolfsegg (DE); HÄRLE, Volker, 93164 Laaber (DE); HAHN, Berthold, 93155 Hemau (DE)
(74) Vertreter: Epping - Hermann - Fischer
(86) Internationale Anmeldenummer: PCT/DE2001/000706
(87) Internationale Veröffentlichungsnummer: WO 2001/063709

(56) Entgegenhaltungen:
- EP-A- 0 851 542
- EP-A2- 0 231 075
- US-A- 5 879 961
- US-A- 5 966 396
- PATENT ABSTRACTS OF JAPAN vol. 1998, no. 02, 30. Januar 1998 (1998-01-30) & JP 09 283854 A (NICHIA CHEM IND LTD), 31. Oktober 1997 (1997-10-31)

## Beschreibung

Die vorliegende Erfindung betrifft ein Verfahren zur Herstellung eines Halbleiterbauelements für die Emission elektromagnetischer Strahlung . Die vorliegende Erfindung betrifft insbesondere eine Halbleiter-LED bzw. einen Halbleiterlaser auf der Basis von Galliumnitrid.

Halbleiter-LEDs bzw. Halbleiterlaser spielen in einer Vielzahl von technischen Systemen eine wichtige Rolle. Insbesondere in der Kommunikationstechnologie, der Informationsverarbeitung sowie Informationsspeicherung und bei der Darstellung von Informationen sind Halbleiter-LEDs bzw. Halbleiterlaser nahezu unverzichtbar. Die dabei eingesetzten herkömmlichen Halbleiter-LEDs bzw. Halbleiterlaser erzeugen in der Regel Licht im roten bzw. infraroten Spektralbereich. Aus einer Vielzahl von Gründen, beispielsweise zur Erhöhung der Speicherdichte, wäre es wünschenswert, Halbleiter-LEDs bzw. Halbleiterlaser mit kürzeren Wellenlängen einzusetzen. Aus diesem Grund finden Halbleiterbauelemente auf der Basis von Galliumnitrid große Beachtung, da mit derartigen Halbleiterbauelementen Licht im blauen bzw. ultravioletten Spektralbereich erzeugt werden kann.

Damit in einem Halbleiterbauelement Strahlung mit hoher Effizienz erzeugt werden kann, ist es in der Regel notwendig den Bereich, der von dem elektrischen Strom durchflossen wird, auf eine definierte Struktur zu begrenzen. Üblicherweise erfolgt diese Begrenzung auf eine räumlich klar definierte Struktur durch einen entsprechend strukturierten Kontaktpad-Anschluss. Dies hat jedoch in der Regel Kontaktpad-Anschlüsse mit relativ kleinen Kontaktflächen zur Folge. Mit der reduzierten Kontaktfläche erhöht sich der Kontaktwiderstand, was u.a. eine unerwünschte Erwärmung des Bauelements bis hin zum Ausfall des Bauelements zur Folge haben kann. Insbesondere bei Bauteilen mit geringer Kontaktanschlussfläche, wie z.B. Lasern tritt dieses Problem besonders in den Vordergrund, und führt zu erheblichen Verschlechterungen der Eigenschaften des Bauelements und der Zuverlässigkeit des Bauelements. So kann der hohe Kontaktwiderstand bei Halbleiterlasern dazu führen, daß der Betrieb des Lasers nur gepulst oder mit externer Kühlung möglich ist.

Leider hat es sich herausgestellt, daß Kontakte auf (In,Al)GaN, einem Halbleiter mit hoher Bandlücke (Eg = 3,39eV bei 300K), besonders problematisch sind. Insbesondere der hohe ohmsche Kontaktwiderstand von Kontakten auf p-leitenden GaN gilt als eines der Haupthindernisse bei der Realisierung von Bauelementen auf der Basis von Galliumnitrid. Deshalb beschäftigen sich eine Vielzahl von Gruppen, Instituten und Chipherstellern mit der Verbesserung der Leitfähigkeit von p-Kontakten auf p-GaN. Die Veröffentlichung "Low-resistance Ta/Ti Ohmic contacts for p-type GaN" (Suzuki et al.) Applied Physics Letters Vol. 74, Nummer 2 (11.1.1999) offenbart beispielsweise die Verwendung von Ta/Ti als Kontaktmaterial anstatt des herkömmlichen Kontaktmaterials Ni/Au, um den Kontaktwiderstand zu reduzieren. Die Veröffentlichung "Low resistance Pd/Au ohmic contacts to p-type GaN using surface treatment" (Kim et al.) Applied Physics Letters Vol. 73, Nummer 20 (16.11.1998) offenbart eine Vorbehandlung der Kontaktstelle mit Königswasser und eine nachfolgende Erzeugung eines Kontakts mit Pd/Au als Kontaktmaterial.

Leider haben all diese Vorschläge eine Reihe von Nachteilen, so daß weitere Verbesserungen notwendig sind. Bei einer definierten Kontaktpad-Größe ist für einen geringen Kontaktwiderstand sowohl eine hohe Akzeptorkonzentration, als auch eine geringe Schottky-Barrierenhöhe erforderlich. Da alle bislang untersuchten p-Dotierstoffe (Mg, Zn, Be, etc.) tiefe Akzeptor-Übergänge bewirken, kann nur ein Bruchteil dieser DotierStoff-Atome elektrisch aktiviert werden. Beim Überschreiten bestimmter Dotierlevel werden zudem Phänomene der Selbstkompensation beobachtet, die eine Reduzierung der elektrischen p-Leitfähigkeit zur Folge haben. Des weiteren führen eine Reihe bislang nicht restlos verstandener Phänomene (beispielsweise Wasserstoff-Passivierung des Dotierstoffs sowie Stickstoff-Leerstellen) zu einer Verringerung der p-Leitfähigkeit.

Die US Patentschrift 5,966,396 offenbart einen Halbleiterlaser auf der Basis von Galliumnitrid, der eine Mesa-Struktur und einen relativ großen p-Kontakt zur Reduzierung des Kontaktwiderstands aufweist. Um trotz des großen p-Kontakts eine Begrenzung des Stroms auf eine räumlich klar definierte Struktur zu erzielen, werden sogenannte "current blocking layers" verwendet, die entlang der Seiten der durch die aktive Schicht und zwei Mantelschichten gebildeten Mesastruktur angeordnet sind. Zur Erzeugung dieser sogenannten "current blocking layers" muß jedoch die aktive Schicht in der Nähe der Stelle, an der später die Strahlung erzeugt werden soll, geätzt werden und es muß ein zweiter Kristallwachstumprozeß an der Mesastruktur durchgeführt werden, um die "current blocking layers" zu bilden. Die Ätzung der aktiven Schicht und das nachfolgende weitere Kristallwachstum haben jedoch in der Regel Schädigungen in der Kristallstruktur der aktiven Schicht zur Folge, was sich negativ auf die Strahlungserzeugung auswirkt. Darüber hinaus führen Kristallwachstumprozesse an Mesastrukturen im Allgemeinen zu Kristallen minderer Qualität, was sich ebenfalls negativ auf die Eigenschaften des Bauelements auswirkt.

In den Druckschriften EP 0 851 542 A1 und JP 09283854 A werden Halbleiterlaser aus Nitridverbindungshalbleitern offenbart, bei denen jeweils eine Strombegrenzungsschicht zwischen dem n-Kontakt und der aktiven Schicht angeordnet ist. Die Strombegrenzungsschichten sind durch selektive Epitaxie hergestellt, z.B. durch Ätzen und erneutes Aufwachsen einer Schicht in dem zuvor geätzten Bereich. Dies kann sich möglicherweise nachteilig auf die Kristallqualität der nachfolgenden Schichten auswirken.

Es ist daher die Aufgabe der vorliegenden Erfindung ein Verfahren zur Herstellung eines Halbleiterbauelements für die Emission elektromagnetischer Strahlung bereitzustellen, das die genannten Nachteile der herkömmlichen Bauelemente mindert bzw. ganz vermeidet.

Diese Aufgabe wird erfindungsgemäß von dem Verfahren zur Herstellung eines Halbleiterbauelements für die Emission elektromagnetischer Strahlung nach dem unabhängigen Patentanspruch 1 gelöst. Weitere vorteilhafte Ausführungsformen, Eigenschaften und Aspekte der vorliegenden Erfindung ergeben sich aus den abhängigen Ansprüchen, der Beschreibung und den beiliegenden Zeichnungen.

Das erfindungsgemäß hergesteltte Halbleiterbauelement besitzt den Vorteil, daß durch die Strombegrenzungsstruktur entlang des n-leitenden Strompfades ein großflächiger p-Kontakt verwendet werden kann. Eine räumliche Begrenzung des p-Kontakts ist nicht erforderlich. Dementsprechend sinkt der Kontaktwiderstand des p-Kontakts. Je nach Bauelement kann dies eine Reduzierung des Kontaktwiderstands um 1 bis 2 Größenordnungen bedeuten. Entsprechend sinkt der Widerstand des Bauelements als Ganzes, was sich beispielsweise positiv auf den Schwellstrom eines Halbleiterlasers auswirkt. Weiterhin sinkt die thermische Belastung des Kontakts sowie des ganzen Bauelements, was sich wiederum positiv in den Eigenschaften des Bauelements sowie in seinen Alterungsverhalten bemerkbar macht.

Da die Strombegrenzung in zwischen dem n-Kontakt und der aktiven Schicht vorgesehen und die aktive Schicht selbst frei von Strombegrenzungsstrukturen ist, kann auf eine Strukturierung der aktiven Schicht, beispielsweise eine Ätzung der aktiven Schicht, zur Strombegrenzung vermieden werden. Die aktive Schicht kann mit hoher Qualität und in relativ einfacher Weise nach Erzeugung der Strombegrenzungsstruktur erzeugt werden, ohne daß die Bildung der Strombegrenzungsstruktur einen negativen Einfluß auf Qualität der aktiven Schicht hat.

Das erfindungsgemäße Verfahren, besitzt den Vorteil, daß eine Strukturierung der aktiven Schicht, beispielsweise eine durch Ätzung der aktiven Schicht, zur Strombegrenzung vermieden werden. Die aktive Schicht kann mit hoher Qualität und in relativ einfacher Weise nach Erzeugung der Strombegrenzungsstruktur erzeugt werden, ohne daß die Bildung der Strombegrenzungsstruktur einen negativen Einfluß auf Qualität der aktiven Schicht hat.

Nachfolgend wird die Erfindung anhand der Zeichnungen näher erläutert. Es zeigen:
- Fig. 1: ein Halbleiterlaser gemäß einer ersten Aus- führungsform der vorliegenden Erfindung,
- Fig. 2 - 6: ein Verfahren zur Herstellung eines Halblei- terlasers gemäß Fig. 1,
- Fig. 7 - 8: ein erfindungsgemäßes, Verfahren zur Herstellung eines Halbleiterlasers gemäß Fig. 1,
- Fig. 9: ein Halbleiterlaser gemäß einer zweiten Aus- führungsform der vorliegenden Erfindung,
- Fig. 10 - 12: ein Verfahren zur Herstellung eines Halblei- terlasers gemäß Fig. 9,
- Fig_{.} 13: eine dritte Halbleiter-LED
- Fig. 14 - 16: ein Verfahren zur Herstellung einer Halblei- ter-LED gemäß Fig. 13,
- Fig. 17: eine vierte Halbleiter-LED
- Fig. 18 - 20: ein Verfahren zur Herstellung eines Halblei- ter-LED gemäß Fig. 17,

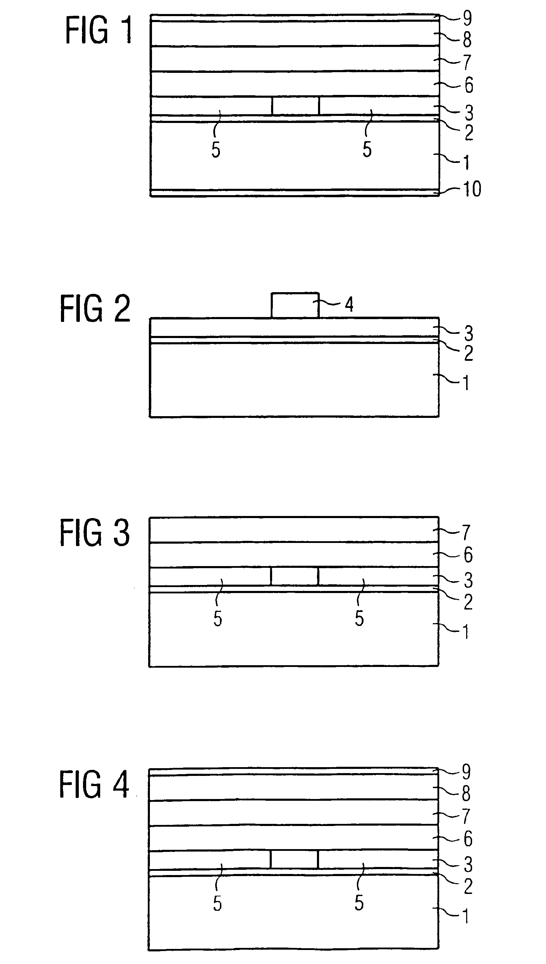

Fig. 1 zeigt einen Halbleiterlaser gemäß einer ersten Ausführungsform der vorliegenden Erfindung. Eine n-leitende InAlGaN-Mantelschicht 3 ist über eine InAlGaN- oder GaN-Zwischenschicht 2 auf einem n-leitenden GaN-Substrat 1 aufgebracht. Anstatt eines n-leitenden GaN-Substrats könnte auch ein n-leitendes SiC-Substrat verwendet werden. Auf der n-leitenden InAlGaN-Mantelschicht 3 ist eine aktive Schicht 6 angeordnet, die zur eigentlichen Strahlungsgenerierung dient. Im vorliegenden Beispiel besitzt die aktive Schicht 6 eine MQW-Struktur (Multiple Quantum Well). Auf der aktiven Schicht 6 ist eine p-leitende InAlGaN-Mantelschicht 7 angeordnet, an die eine p-leitende GaN-Kontaktschicht 8 angrenzt. Auf der Oberseite der p-leitenden GaN-Kontaktschicht 8 ist ein großflächiger p-Kontakt 9 aufgebracht. Der entsprechende n-Kontakt 10 ist der Unterseite des n-leitenden GaN-Substrats angeordnet.

Zur räumlichen Begrenzung des durch die aktive Schicht flieβenden Stroms wurde in der InAlGaN-Mantelschicht 3 eine Strombegrenzungsstruktur 5 erzeugt, die den Strom auf die Mitte der aktiven Schicht 6 einengt. Die Strombegrenzungsstruktur 5 besteht aus einem isolierenden Bereich in der InAlGaN-Mantelschicht 3. Als Alternative zu einem isolierenden Bereich können auch p-leitende Bereiche, welche einen gesperrten pn-Übergang bilden, als Strombegrenzungsstruktur 5 verwendet werden. Durch die räumliche Begrenzung des Stroms kann die Laserschwelle in der Mitte der aktiven Schicht 6 schon bei einem relativ geringen Strom erreicht werden. Gleichzeitig ist der Widerstand des Lasers aufgrund des großflächigen p-Kontakts deutlich reduziert.

Die Figuren 2 bis 6 zeigen ein Verfahren zur Herstellung eines Halbleiterlasers gemäß Fig. 1. Dabei werden mit Hilfe von MOCVD-Verfahren epitaktisch die n-leitende InAlGaN- oder GaN-Zwischenschicht 2 und die n-leitende InAlGaN-Mantelschicht 3 nacheinander auf das GaN-Substrat 1 aufgebracht. Dabei kann die Zwischenschicht 2 auch weggelassen und die InAlGaN-Mantelschicht 3 direkt auf das GaN-Substrat aufgebracht werden. Weiterhin kann anstelle eines MOCVD-Verfahren auch ein MBE-Verfahren (Molecular Beam Epitaxie) eingesetzt werden. Anschließend wird auf die n-leitende InAlGaN-Mantelschicht 3 eine Maskenschicht, beispielsweise eine Al₂O₃-, SiO₂- oder Si₃N₄-Schicht, aufgebracht, die mit Hilfe einer Phototechnik zur Maske 4 strukturiert wird. Die sich daraus ergebende Situation ist in Fig. 2 gezeigt.

Durch eine Implantation von Wasserstoffionen H⁺ werden nun die Bereiche der n-leitenden InAlGaN-Mantelschicht 3, die nicht von der Maske 4 abgedeckt sind, isolierend, d.h. ihr Widerstand vergrößert sich um mehrere Größenordnungen. Die Implantation von Wasserstoffionen H⁺ kann beispielsweise mit einer Energie von 100 bis 300 keV und einer Dosis von 1x10¹⁵ 1/cm² durchgeführt werden. Die isolierenden Bereiche bilden die Strombegrenzungsstruktur 5, die den Strom auf die Mitte der noch zu erzeugenden aktiven Schicht 6 einengt. Als Alternative zu einer Implantation von Wasserstoffionen H⁺ kann auch eine partielle Oxidation der InAlGaN-Mantelschicht 3 durchgeführt werden. Dazu wird die in Fig. 2 gezeigte Struktur einer Sauerstoffatmosphäre ausgesetzt, wodurch die Bereiche der InAlGaN-Mantelschicht 3, die nicht von der Maske 4 abgedeckt sind, ihre leitenden Eigenschaften verlieren. Die so entstandenen isolierenden Bereiche bilden wiederum die Strombegrenzungsstruktur 5, die den elektrischen Strom auf die Mitte der noch zu erzeugenden aktiven Schicht 6 einengt.

Anstelle von isolierenden Bereichen können auch p-leitende Bereiche als Strombegrenzungsstruktur 5 eingesetzt werden. Dazu werden anstatt Wasserstoffionen H⁺ p-Dotierstoffe, wie Mg, Zn, Be, C oder Ca, in die InAlGaN-Mantelschicht 3 implantiert bzw. diffundiert. Die Maske 4 schützt dabei wiederum den Bereich der InAlGaN-Mantelschicht 3, der später als n-leitender Strompfad dienen soll. Die Implantation von p-Dotierstoffen kann beispielsweise mit einer Energie von 60 bis 200 keV und einer Dosis von 1x10¹⁴ bis 5x10¹⁶ 1/cm² durchgeführt werden. Bei einer Mg-Implantation kann durch eine Co-Implantation von Phosphor die erzeugte Löcherkonzentration gesteigert werden. Die p-leitenden Bereiche bilden mit der n-leitenden Zwischenschicht 2 bzw. dem n-leitenden Substrat 1 einen sperrenden pn-Übergang, so daß der Stromfluß auf den noch verbliebenen n-leitenden Bereich der InAlGaN-Mantelschicht 3 beschränkt ist.

Durch die Implantation kommt es zu Störungen in der Kristallstruktur der InAlGaN-Mantelschicht 3. Diese Störungen werden durch einen Annealschritt bei einer Temperatur von etwa 1000° bis 1700°C ausgeheilt. Da bei diesen Temperaturen der Stickstoff in InAlGaN-Mantelschicht 3 abzudampfen beginnt, wird vor dem Annealschritt eine Schutzschicht (nicht gezeigt), beispielsweise eine SiO₂-Schicht oder eine AlN-Schicht, aufgebracht. Diese Schutzschicht wird nach dem Annealschritt wieder entfernt. Zur Reduzierung der Störungen in der Kristallstruktur kann auch bereits die Implantation bei höheren Temperaturen, beispielsweise bei 500°C, durchgeführt werden.

Nach Erzeugung der Strombegrenzungsstruktur 5 wird die Maske 4 entfernt und es werden eine aktive (InAl)GaN-Schicht 6 und eine p-leitende InAlGaN-Mantelschicht 7 durch MOCVD-Verfahren epitaktisch aufgebracht. Im vorliegenden Beispiel besitzt die aktive (InAl)GaN-Schicht 6 eine MQW-Struktur (Multiple Quantum Well) zur Erhöhung der Effizienz der Strahlungserzeugung. Weiterhin bilden die aktive (InAl)GaN-Schicht 6, die p-leitende InAlGaN-Mantelschicht 7 und die n-leitende InAlGaN-Mantelschicht 3 eine Doppel-Heterostruktur, um die Effizienz der Ladungsinjektion in die aktive (InAl)GaN-Schicht 6 zu erhöhen. Die sich daraus ergebende Situation ist in Fig. 3 gezeigt.

Anschließend wird eine weitere p-leitende Schicht, die GaN-Kontaktschicht 8, epitaktisch auf die p-leitende InAlGaN-Mantelschicht 7 aufgebracht. Auf der p-leitenden GaN-Kontaktschicht 8 wird nun der p-Kontakt 9 erzeugt, wodurch sich die in Fig. 4 gezeigte Situation ergibt. Nach der nun folgenden Erzeugung des n-Kontakts an der Unterseite des GaN-Substrats 1 ist der Halbleiterlaser im wesentlichen fertig.

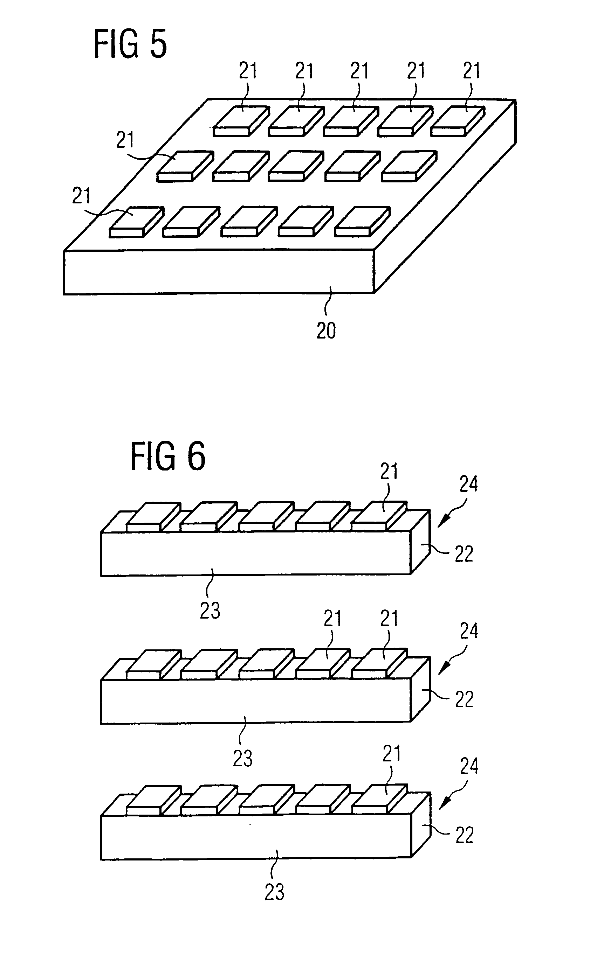

Bei der Herstellung von Halbleiterlasern werden jeweils eine Vielzahl von Halbleiterlasern gleichzeitig auf einem Halbleiterwafer 20 produziert. Fig. 5 zeigt schematisch einen Halbleiterwafer mit einer Viehzahl von Halbleiterlasern 21. Zur endgültigen Fertigstellung der Halbleiterlaser 21 wird der Halbleiterwafer 20 nun in einzelne Barren 22 gespalten (Fig. 6). Anschließend werden die Vorderseite 23 und die Rückseite 24 der Barren 22 verspiegelt und die Halbleiterlaser 21 vereinzelt.

Durch die Tatsache, daß bei dem Halbleiterbauelement der vorliegenden Erfindung die Strombegrenzungsstruktur zur Definition eines Strompfades zwischen dem n-Kontakt und aktiven Schicht vorgesehen ist und die aktive Schicht zur Bildung der Strombegrenzungsstrukturen nicht strukturiert werden muß, kann die aktive Schicht auf relativ einfache Weise und in hoher Qualität erzeugt werden. Gleichzeitig kann ein großflächiger p-Kontakt eingesetzt werden, was den Kontaktwiderstand des p-Kontakts und damit den Gesamtwiderstand des Halbleiterbauelements deutlich reduziert.

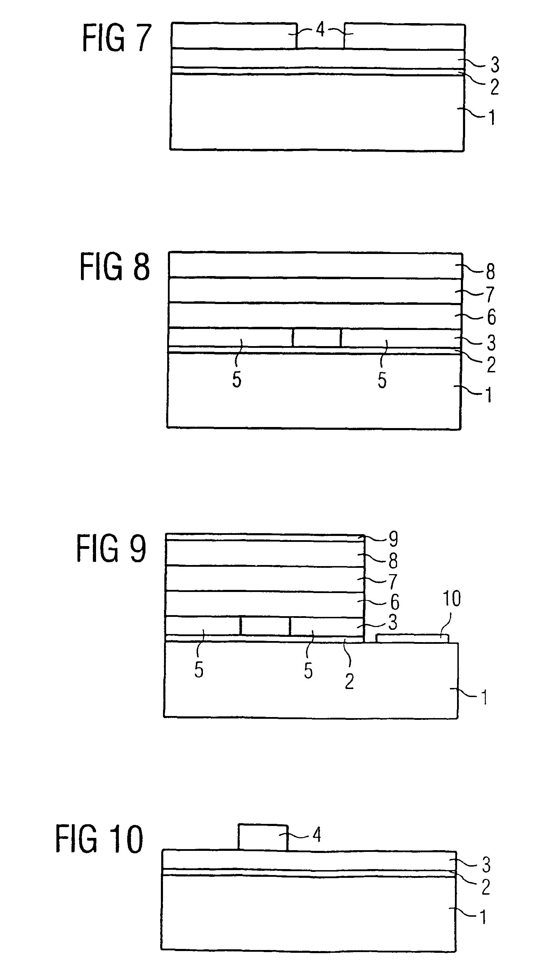

Die Figuren 7 bis 8 zeigen ein erfindungsgemäßes Verfahren zur Herstellung eines Halbleiterlasers gemäß Fig. 1. Dabei werden mit Hilfe von MOCVD-Verfahren epitaktisch eine n-leitende InAlGaN- oder GaN-Zwischenschicht 2 und eine p-leitende InAlGaN-Mantelschicht 3 nacheinander auf das GaN-Substrat 1 aufgebracht. Dabei kann die Zwischenschicht 2 auch weggelassen und die InAlGaN-Mantelschicht 3 direkt auf das GaN-Substrat aufgebracht werden. Weiterhin kann als Alternative auch eine isolierende InAlGaN-Mantelschicht 3, beispielsweise durch den Einbau eines isolierenden Dotierstoffs wie Wasserstoff, verwendet werden. Anschließend wird auf die p-leitende (isolierende) InAlGaN-Mantelschicht 3 eine Maskenschicht, beispielsweise eine Al₂O₃-, SiO₂- oder Si₃N₄-Schicht, aufgebracht, die mit Hilfe einer Phototechnik zur Maske 4 strukturiert wird. Die sich daraus ergebende Situation ist in Fig. 7 gezeigt.

Durch eine Implantation oder Diffusion von n-Dotierstoffen, beispielsweise Si oder O, werden nun die Bereiche der p-leitenden InAlGaN-Mantelschicht 3, die nicht von der Maske 4 abgedeckt sind, n-leitend. Die Implantation von n-Dotierstoffen kann beispielsweise mit einer Energie von 50 bis 100 keV und einer Dosis von 1x10¹⁴ bis 5x10¹⁴ 1/cm² durchgeführt werden. Die zurückbleibenden p-leitenden Bereiche der InAlGaN-Mantelschicht 3 bilden die Strombegrenzungsstruktur 5, während der n-leitende Bereich den Strompfad zu der noch zu bildenden aktiven Schicht darstellt. Als Alternative zu einer Implantation von n-Dotierstoffen kann auch eine thermische Erzeugung von n-Leerstellen in den ungeschützten Bereichen der p-leitenden InAlGaN-Mantelschicht 3 durchgeführt werden.

Wird anstelle der p-leitenden InAlGaN-Mantelschicht 3 eine isolierende InAlGaN-Mantelschicht 3 verwendet, so kann durch eine thermische Behandlung der isolierende Dotierstoff aus den von der Maske 4 nicht bedeckten Bereichen der isolierenden InAlGaN-Mantelschicht 3 ausgetrieben werden, wodurch ebenfalls ein n-leitender Bereich in der InAlGaN-Mantelschicht 3 entsteht. Zum Austreiben von Wasserstoff wird beispielsweise die Struktur auf 700° bis 1000°C, bevorzugt auf 800° bis 900°C (besonders bevorzugt 850°C) erwärmt.

Nach Erzeugung der Strombegrenzungsstruktur 5 wird die Maske 4 entfernt und es werden eine aktive (InAl)GaN-Schicht 6, eine p-leitende InAlGaN-Mantelschicht 7 und eine p-leitende GaN-Kontaktschicht 8 durch MOCVD-Verfahren epitaktisch aufgebracht (Fig. 8). Anschließend werden nun der p-Kontakt 9 und der n-Kontakt 10 erzeugt, wodurch sich die in Fig. 1 gezeigte Situation ergibt.

Fig. 9 zeigt ein Halbleiterlaser gemäß einer zweiten Ausführungsform der vorliegenden Erfindung. Der in Fig. 9 gezeigte Halbleiterlaser entspricht im wesentlichen dem in Fig. 1 gezeigten Halbleiterlaser. Im Gegensatz zu dem in Fig. 1 gezeigten Halbleiterlaser ist jedoch bei dem in Fig. 9 gezeigte Halbleiterlaser der n-Kontakt 10 auf der Oberseite des Substrats 1 angeordnet.

Die Figuren 10 bis 12 zeigen ein Verfahren zur Herstellung eines Halbleiterlasers gemäß Fig. 9. Dabei werden wiederum mit Hilfe von MOCVD-Verfahren epitaktisch die n-leitende InAlGaN- oder GaN-Zwischenschicht 2 und die n-leitende InAlGaN-Mantelschicht 3 nacheinander auf das GaN-Substrat 1 aufgebracht. Anschließend wird auf die n-leitende InAlGaN-Mantelschicht 3 eine Maskenschicht, beispielsweise eine Al₂O₃-, SiO₂- oder Si₃N₄-Schicht, aufgebracht, die mit Hilfe einer Phototechnik zur Maske 4 strukturiert wird. Die sich daraus ergebende Situation ist in Fig. 10 gezeigt.

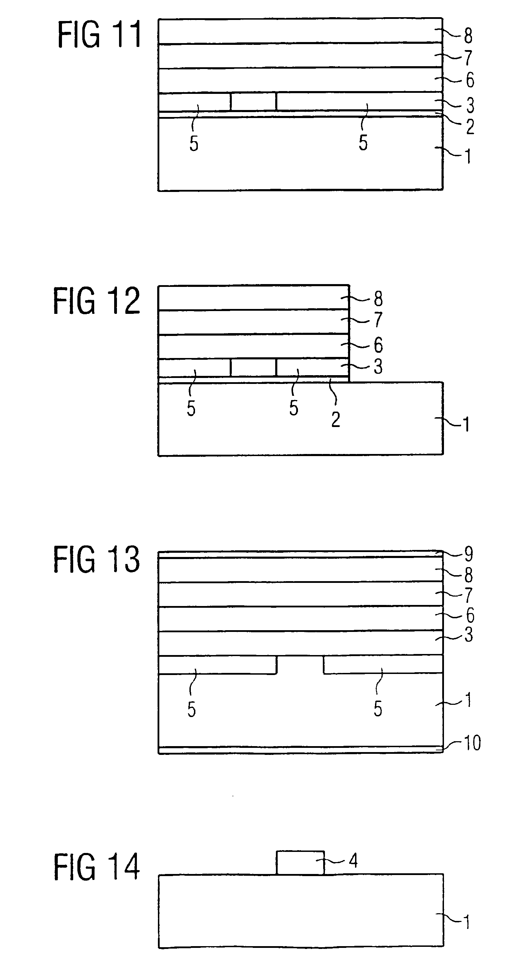

Durch eine Implantation von Wasserstoffionen H⁺ bzw. eine partielle Oxidation werden nun die Bereiche der n-leitenden InAlGaN-Mantelschicht 3, die nicht von der Maske 4 abgedeckt sind, isolierend. Die isolierenden Bereiche bilden die Strombegrenzungsstruktur 5, wodurch der Stromfluß auf den noch verbliebenen n-leitenden Bereich der InAlGaN-Mantelschicht 3 beschränkt ist. Nach Erzeugung der Strombegrenzungsstruktur 5 wird die Maske 4 entfernt und es werden eine aktive (InAl)GaN-Schicht 6, eine p-leitende InAlGaN-Mantelschicht 7 und eine p-leitende GaN-Kontaktschicht 8 durch MOCVD-Verfahren epitaktisch aufgebracht. Die sich daraus ergebende Situation ist in Fig. 11 gezeigt.

Um einen n-Kontakt auf der Oberseite des Substrats 1 erzeugen zu können, werden die aufgebrachten Schichten anisotrop geätzt bis die Oberfläche des Substrats 1 freigelegt ist. Diese Strukturierung kann beispielsweise mit Hilfe einer Trockenätzung unter Verwendung von Chlorgas und einer SiO₂-Maske durchgeführt werden. Die sich daraus ergebende Situation ist in Fig. 12 gezeigt. Anschließend werden, wie in Fig. 9 gezeigt, der p-Kontakt und der n-Kontakt erzeugt.

Fig. 13 zeigt eine dritte Halbleiter-LED . Eine n-leitende InAlGaN-Mantelschicht 3 ist auf einem n-leitenden GaN-Substrat 1 aufgebracht. Anstatt eines n-leitenden GaN-Substrats könnte auch ein n-leitendes SiC-Substrat verwendet werden. In diesem Fall ist es jedoch vorteilhaft, eine Zwischenschicht zwischen Substrat und Mantelschicht zu verwenden. Auf der n-leitenden InAlGaN-Mantelschicht 3 ist eine aktive Schicht 6 angeordnet, die zur eigentlichen Strahlungsgenerierung dient. Auf der aktiven Schicht 6 ist eine p-leitende InAlGaN-Mantelschicht 7 angeordnet, an die eine p-leitende GaN-Kontaktschicht 8 angrenzt. Auf der Oberseite der p-leitenden GaN-Kontaktschicht 8 ist ein großflächiger p-Kontakt 9 aufgebracht. Der entsprechende n-Kontakt 10 ist der Unterseite des n-leitenden GaN-Substrats 1 angeordnet.

Zur räumlichen Begrenzung des durch die aktive Schicht flieβenden Stroms wurde in dem GaN-Substrat 1 eine Strombegrenzungsstruktur 5 erzeugt, die den Strom auf die Mitte der aktiven Schicht 6 einengt. Die Strombegrenzungsstruktur 5 besteht aus einem isolierenden Bereich in dem GaN-Substrat 1. Als Alternative zu einem isolierenden Bereich können auch p-leitende Bereiche, welche einen gesperrten pn-Übergang bilden, als Strombegrenzungsstruktur 5 verwendet werden.

Die Figuren 14 bis 16 zeigen ein Verfahren zur Herstellung einer Halbleiter-LED gemäß Fig. 13. Dabei wird auf das n-leitende GaN-Substrat 1 eine Maskenschicht, beispielsweise eine Al₂O₃-, SiO₂- oder Si₃N₄-Schicht, aufgebracht, die mit Hilfe einer Phototechnik zur Maske 4 strukturiert wird. Die sich daraus ergebende Situation ist in Fig. 14 gezeigt.

Durch eine Implantation von Wasserstoffionen H⁺ bzw. eine partielle Oxidation werden nun die Bereiche des n-leitenden GaN-Substrats 1, die nicht von der Maske 4 abgedeckt sind, isolierend. Die isolierenden Bereiche bilden die Strombegrenzungsstruktur 5, wodurch der Stromfluß auf den noch verbliebenen n-leitenden Bereich der GaN-Substrats 1 beschränkt ist. Anstelle von isolierenden Bereichen können auch p-leitende Bereiche als Strombegrenzungsstruktur 5 eingesetzt werden. Dazu werden anstatt Wasserstoffionen H⁺ p-Dotierstoffe, wie Mg, Zn, Be oder Ca, in das GaN-Substrat 1 implantiert bzw. diffundiert. Die Maske 4 schützt dabei wiederum den Bereich des GaN-Substrats 1, der später als n-leitender Strompfad dienen soll.

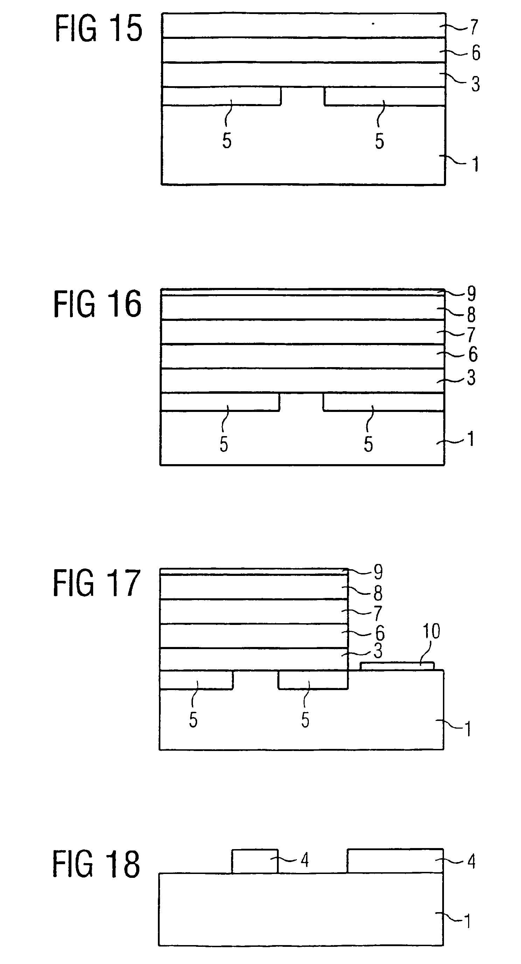

Nach Erzeugung der Strombegrenzungsstruktur 5 wird die Maske 4 entfernt und es werden eine n-leitende InAlGaN-Mantelschicht 3, eine aktive InGaN-Schicht 6 und eine p-leitende InAIGaN-Mantelschicht 7 durch MOCVD-Verfahren epitaktisch aufgebracht. Im vorliegenden Beispiel bilden die aktive InGaN-Schicht 6, die p-leitende InAlGaN-Mantelschicht 7 und die n-leitende InAlGaN-Mantelschicht 3 eine Doppel-Heterostruktur, um die Effizienz der Ladungsinjektion in die aktive InGaN-Schicht 6 zu erhöhen. Die sich daraus ergebende Situation ist in Fig. 15 gezeigt.

Anschließend wird eine weitere p-leitende Schicht, die GaN-Kontaktschicht 8, epitaktisch auf die p-leitende InAlGaN-Mantelschicht 7 aufgebracht. Auf der p-leitenden GaN-Kontaktschicht 8 wird nun der p-Kontakt 9 erzeugt, wodurch sich die in Fig. 16 gezeigte Situation ergibt. Nach der nun folgenden Erzeugung des n-Kontakts an der Unterseite des GaN-Substrats 1 ist die Halbleiter-LED im wesentlichen fertig.

Fig. 17 zeigt eine vierte Halbleiter-LED . Die in Fig. 17 gezeigte Halbleiter-LED entspricht im wesentlichen der in Fig. 13 gezeigten Halbleiter-LED. Im Gegensatz zu der in Fig. 13 gezeigten Halbleiter-LED ist jedoch bei der in Fig. 17 gezeigten Halbleiter-LED der n-Kontakt 10 auf der Oberseite des GaN-Substrats 1 angeordnet.

Die Figuren 18 bis 20 zeigen ein Verfahren zur Herstellung einer Halbleiter-LED gemäß Fig. 17. Dabei wird wiederum eine Maskenschicht, beispielsweise eine Al₂O₃-, SiO₂- oder Si₃N₄-Schicht, auf das GaN-Substrat 1 aufgebracht, die mit Hilfe einer Phototechnik zur Maske 4 strukturiert wird. Die Maske 4 deckt dabei nicht nur die Bereiche ab, die später als Strompfad dienen, sondern auch die Bereiche, an denen später der n-Kontakt angeordnet wird. Die sich daraus ergebende Situation ist in Fig. 18 gezeigt.

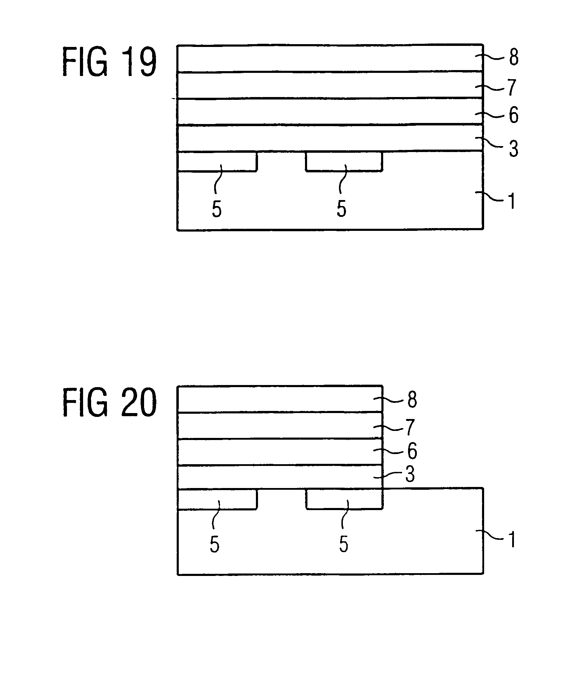

Durch eine Implantation von Wasserstoffionen H⁺ bzw. eine partielle Oxidation werden nun die Bereiche des n-leitenden GaN-Substrats 1, die nicht von der Maske 4 abgedeckt sind, isolierend. Die isolierenden Bereiche bilden die Strombegrenzungsstruktur 5, wodurch der Stromfluß auf den noch verbliebenen n-leitenden Bereich der GaN-Substrats 1 beschränkt ist. Anstelle von isolierenden Bereichen können auch p-leitende Bereiche als Strombegrenzungsstruktur 5 eingesetzt werden. Dazu werden anstatt Wasserstoffionen H⁺ p-Dotierstoffe, wie Mg, Zn, Be oder Ca, in das GaN-Substrat 1 implantiert bzw. diffundiert. Die Maske 4 schützt dabei wiederum die Bereiche des GaN-Substrats 1, die später als n-leitender Strompfad bzw. n-Kontakt dienen sollen. Nach Erzeugung der Strombegrenzungsstruktur 5 wird die Maske 4 entfernt und es werden eine n-leitende InAlGaN-Mantelschicht 3, eine aktive InGaN-Schicht 6, eine p-leitende InAlGaN-Mantelschicht 7 und eine p-leitende GaN-Kontaktschicht 8 durch MOCVD-Verfahren epitaktisch aufgebracht. Die sich daraus ergebende Situation ist in Fig. 19 gezeigt.

Um einen n-Kontakt auf der Oberseite des GaN-Substrats 1 erzeugen zu können, werden die aufgebrachten Schichten anisotrop geätzt bis die Oberfläche des GaN-Substrats 1 freigelegt ist. Diese Strukturierung kann beispielsweise mit Hilfe einer Trockenätzung unter Verwendung von Chlorgas und einer SiO₂-Maske durchgeführt werden. Die sich daraus ergebende Situation ist in Fig. 20 gezeigt. Anschließend werden, wie in Fig. 17 gezeigt, der p-Kontakt und der n-Kontakt erzeugt.

## Patentansprüche

1. Verfahren zur Herstellung eines Halbleiterbauelements für die Emission elektromagnetischer Strahlung, insbesondere Licht, mit den Schritten:
a) ein n-leitendes Substrat (1) wird bereitgestellt,
b) auf das n-leitende Substrat (1) wird zumindest eine p-leitende und/oder elektrisch isolierende Schicht (3) aufgebracht,
c) auf die p-leitende und/oder elektrisch isolierende Schicht (3) wird eine Maske (4) aufgebracht,
d) in die von der Maske (4) unbedeckten Bereiche der p-leitenden und/oder elektrisch isolierenden Schicht (3) wird ein n-Dotierstoff implantiert oder diffundiert, so dass ein n-leitender Strompfad in der p-leitenden und/oder elektrisch isolierenden Schicht (3) erzeugt und so eine Strombegrenzungsstruktur (5) gebildet wird,
e) auf die p-leitende und/oder elektrisch isolierende Schicht (3) wird eine aktive Schicht (6) zur Strahlungserzeugung aufgebracht,
f) auf die aktive Schicht (6) wird zumindest eine p-leitende Schicht (7) aufgebracht, und
g) ein p-Kontakt (9) und ein n-Kontakt (10) werden erzeugt.

2. Verfahren nach Anspruch 1,
**dadurch gekennzeichnet,**
**daß** als Maske (4) eine Al₂O₃-, SiO₂- oder Si₃N₄-Maske verwendet wird.

3. Verfahren nach Anspruch 1 oder 2,
**dadurch gekennzeichnet,**
**daß** das Substrat ein n-leitendes GaN-Substrat oder ein n-leitendes SiC-Substrat ist.

4. Verfahren nach einem der vorhergehenden Ansprüche,
**dadurch gekennzeichnet,**
**daß** der n-Dotierstoff Si oder O ist.

## Claims

1. A method of producing a semiconductor component for emitting electromagnetic radiation, in particular light, having the following steps:
a) an n-conducting substrate (1) is provided,
b) at least one p-conducting and/or electrically insulating layer (3) is applied to the n-conducting substrate (1),
c) a mask (4) is applied to the p-conducting and/or electrically insulating layer (3),
d) an n-dopant is implanted or diffused into the regions of the p-conducting and/or electrically insulating layer (3) not covered by the mask (4), such that an n-conducting current path is produced in the p-conducting and/or electrically insulating layer (3) and a current confinement structure (5) is thus formed,
e) an active layer (6) for generating radiation is applied to the p-conducting and/or electrically insulating layer (3),
f) at least one p-conducting layer (7) is applied to the active layer (6), and
g) a p-contact (9) and an n-contact (10) are produced.

2. A method according to claim 1,
**characterised in that** an Al₂O₃, SiO₂ or Si₃N₄ mask is used as the mask (4).

3. A method according to claim 1 or claim 2,
**characterised in that** the substrate is an n-conducting GaN substrate or an n-conducting SiC substrate.

4. A method according to any one of the preceding claims, **characterised in that** the n-dopant is Si or O.

## Revendications

1. Procédé de fabrication d'un composant de semi-conducteur pour l'émission de rayonnement électromagnétique, notamment de lumière, comprenant les étapes :
a) un substrat (1) à conductivité de type n est préparé,
b) sur le substrat (1) à conductivité de type n est appliquée au moins une couche (3) à conductivité de type p et/ou électriquement isolante,
c) sur la couche (3) à conductivité de type p et/ou électriquement isolante est appliqué un masque (4),
d) dans les parties, non recouvertes par le masque (4), de la couche (3) à conductivité de type p et/ou électriquement isolante est implantée ou diffusée une substance dopée n, de sorte qu'un trajet du courant à conductivité de type n est généré dans la couche (3) à conductivité de type p et/ou électriquement isolante et qu'une structure de limitation du courant (5) est ainsi formée,
e) sur la couche (3) à conductivité de type p et/ou électriquement isolante est appliquée une couche active (6) destinée à générer le rayonnement,
f) sur la couche active (6) est appliquée au moins une couche (7) à conductivité de type p, et
g) un contact p (9) et un contact n (10) sont générés.

2. Procédé selon la revendication 1,
**caractérisé en ce qu'**un masque (4) Al₂O₃, SiO₂ ou Si₃N₄ est utilisé comme masque.

3. Procédé selon la revendication 1 ou 2,
**caractérisé en ce que** le substrat est un substrat GaN à conductivité de type n ou un substrat SiC à conductivité de type n.

4. Procédé selon l'une quelconque des revendications précédentes,
**caractérisé en ce que** la substance dopée n est du silicium ou de l'oxygène.
